# EUROPÄISCHE PATENTSCHRIFT

(11) **EP 0 618 451 B1**
(45) Veröffentlichungstag und Bekanntmachung des Hinweises auf die Patenterteilung: **21.02.1996**
(21) Anmeldenummer: 93103524.0
(22) Anmeldetag: 05.03.1993
(51) Int. Cl.: G01R 15/18, H01F 38/28, G01R 11/06, G01R 21/00

(54) **Stromwandler, insbesondere für einen elektronischen Elektrizitätszähler**
Current transducer particularly for an electronic electricity meter
Capteur de courant en particulier pour un compteur d'énergie électrique

(43) Veröffentlichungstag der Anmeldung: 05.10.1994
(73) Patentinhaber: DEUTSCHE ZAEHLER-GESELLSCHAFT, D-22083 Hamburg (DE)
(72) Erfinder: Herrmann, Frank, Dipl.-Ing., W-3300 Braunschweig (DE); Rätsch, Otto, Dipl.-Ing., W-2071 Ammersbek 1 (DE)
(74) Vertreter: Richter, Werdermann & Gerbaulet

(56) Entgegenhaltungen:
- EP-A- 0 481 104
- DE-A- 2 505 761
- DE-C- 507 820
- FR-A- 2 594 230
- US-A- 4 591 942

## Beschreibung

Der Stromwandler ist überall dort einsetzbar, wo Strommessungen vorgenommen werden sollen.

Die Erfindung betrifft einen Stromwandler mit einem vom zu messenden Strom durchflossenen, eine wenigstens annähernd in einer Ebene liegende, etwa U-förmige Leiter-Schleife bildenden Leiter, in dessen Innerem eine an einen elektronischen Elektrizitätszähler anschließbare Spule angeordnet ist, deren Windungen zur Ebene der Leiter-Schleife wenigstens annähernd parallel liegen, wobei die Leiter-Schleife und die Spule von einem, auch als Abschirmung wirkenden Mantel aus magnetisch leitendem Material umschlossen sind.

Aus der EP-A-0481 104, welche den nächstkommenden Stand der Technik gemäß den Merkmalen des Oberbegriffs des Anspruches 1 darstellt, ist ein Stromwandler mit einem vom zu messenden Strom durchflossenen, eine wenigstens annähernd in einer Ebene liegende, etwa U-förmige Leiter-Schleife bildenden Leiter bekannt. Im Inneren des Leiters ist eine an einen elektronischen Elektrizitätszähler anschließbare Spule angeordnet, deren Windungen zur Ebene der Leiter-Schleife wenigstens annähernd parallel liegen, wobei die Leiter-Schleife und die Spule von einem, auch als Abschirmung wirkenden Mantel aus magnetisch leitendem Material umschlossen sind.

Die DE-A-25 05 761 betrifft einen Magnetkreis für eine Strommesseinrichtung, der insbesondere für einen Differenztransformator oder -wandler vorgesehen ist. Der Magnetkreis besteht hier aus einem Stapel dünner Platten, die von einander durch dünne, elektrischisolierende Schichten getrennt sind.

Jede Platte weist zwei eingeschnittene längliche Fenster auf, deren Übereinanderlagerung zwei Öffnungen bildet, die in Richtung der kleinsten Dickenausdehnung den Magnetkreis druchsetzen, der die Form eines ebenen prismatischen Blocks aufweist. Die Leiter sind in diesen Öffnungen aufgenommen, ebenso wie der Sekundär(strom)kreis bzw. dessen Leiter, der eine Schleife um den Innenkern des Magnetkreises bildet.

Der Erfindung liegt die Aufgabe zugrunde, die für die Führung des magnetischen Flusses und als Abschirmung vorgesehenen Teile so auszubilden und anzuordnen, daß einerseits Herstellung und Zusammenbau einfach sind und andererseits ohne aufwendige Justierung eine hohe Langzeit-Stabilität erreicht wird.

Diese Aufgabe wird durch die Merkmale des kennzeichnenden Teils des Anspruch 1 gelöst.

Hierzu ist vorgesehen, daß der weichmagnetische Mantel gebildet wird durch mindestens ein flaches lamellenförmiges Element, dessen Ebene zur Ebene der Leiter-Schleife annähernd senkrecht steht. Dabei wird die U-förmige Leiter-Schleife gebildet durch zwei etwa gerade Schenkel und einen die beiden Schenkel verbindenden Bogen, und das lamellenfförmige Element trägt eine längliche Öffnung, die an ihren Enden als Durchlaß für die Schenkel der Leiter-Schleife ausgebildet ist und die dazwischen Platz für die Spule bietet, wobei der die Öffnung umschließende Teil des Elementes neben dem in der Öffnung für die Spule vorgesehenen Bereich mit wenigstens einem, in der Ebene des lamellenförmigen Elementes liegenden Vorsprung versehen ist.

Vorteilhaft ist der Durchlaß in der Öffnung für einen Leiter an dessen Querschnitt zuzüglich einer elektrischen Isolierschicht angepaßt. Dabei kann der Leiter z.B. rund sein oder rechteckig, wobei die Höhe des Leiters senkrecht zur Ebene der Leiter-Schleife größer, z.B. 1,5 bis 3 mal größer, ist als seine Breite parallel zur Ebene der Leiter-Schleife.

Nach einer vorteilhaften Ausführungsform ist der die Öffnung umschließende Mantel-Teil neben dem für die Spule vorgesehenen Bereich mit zwei, in der Ebene des lamellenförmigen Elementes gegenüberliegenden, Vorsprüngen versehen. Zweckmäβig ist zwischen den Vorsprüngen ein Raum freigelassen, in dem die Spule, ggf. mit einem Spulenkörper, angeordnet werden kann. Dabei ist der Raum zwischen den Vorsprüngen zweckmäßig etwas, z.B. ein bis zwei Millimeter, größer als die Dicke der Leiter senkrecht zur Ebene der Leiter-Schleife; so kann wenigstens ein lamellenförmiges Element über den geschlossenen Bogen der U-förmigen Leiter-Schleife zur Spule hin aufgeschoben werden.

Ein besonderer zusätzlicher ferromagnetischer Kern ist dabei nicht erforderlich, wenn nach einer Ausführungsform die Höhe der Spule und der freie Raum zwischen den Vorsprüngen so ausgebildet sind, daß sie den für den Betrieb des Stromwandlers erforderlichen Solluftspalt bildet. Die Vorsprünge wirken dann gewissermaßen wie Polschuhe, während die äußeren Teile des lamellenförmigen Elementes einen geschlossenen ferromagnetischen Kreis ohne Luftspalt darstellen.

Zweckmäßig ist die Höhe des lamellenförmigen Elementes zwischen der an den Luftspalt grenzenden Kante eines Vorsprunges bis zu seiner Außenseite wenigstens annähernd so groß wie der halbe Außendurchmesser der Spule, deren Achse wenigstens annähernd senkrecht zur Ebene der Leiter-Schleife liegt. Dadurch wird sichergestellt, daß die Magnetfeldlinien ausreichend gut von dem ferromagnetischen Material des lamellenförmigen Elementes aufgenommen werden. Die Höhe des lamellenförmigen Elementes zwischen den gegenüberliegenden parallel zur Ebene der Leiter-Schleife verlaufenden Außenseiten soll zweckmäßig mindestens zweimal, vorzugsweise etwa dreimal, so groß sein wie der Abstand zwischen den Vorsprüngen.

Die Spule, die vorteilhaft ohne ferromagnetischen Kern ausgebildet ist, soll zweckmäßig flach gestaltet sein mit einem Außendurchmesser, der größer, zweckmäßig mindestens zweimal größer, ist als die Spulenhöhe. Die Spulenhöhe kann etwas kleiner sein als der Raum zwischen den gegenüberliegenden Vorsprüngen derart, daß die Lamellen von der Seite über die Spule geschoben werden können.

Nach einer Ausführungsform der Erfindung ist die Spule auf einem Träger aus isolierendem Material angebracht. Der Träger kann aus zwei Teilen bestehen, die von gegenüberliegenden Seiten der Leiter-Schleife montiert werden können, so daß die Anordnung von der Seite her angebracht werden kann und die stromführende Leitung nicht wegen des Stromwandlers aufgeteilt werden muß.

Wenigstens ein lamellenförmiges Element soll nahe der Spulenmitte angeordnet werden; dieses ist dann maßgebend für das Zuführen des Magnetflusses von dem U-förmigen Leiter zur Mitte der Spule, wodurch beide Teile magnetisch gekoppelt sind.

Wenigstens ein lamellenförmiges Element kann in der Nähe des Spulenrandes angebracht sein. Dieses dient dazu, etwa von auβen kommende Fremdfelder von der Spule und somit von einer Einwirkung auf den Meßkreis fernzuhalten. Gerade bei einem Elektrizitätszähler muß ja mit minimalen Primärströmen, auch einem fehlendem Primärstrom, gerechnet werden, so daß selbst kleine Fremdfelder abgeschirmt werden müssen, um Fehler zu vermeiden.

In der Regel wird man mit wenigen lamellenförmigen Elementen auskommen, und zwischen zwei benachbarten magnetisch leitenden lamellenförmigen Elementen kann nichtmagnetisches Material, z.B. Aluminium oder Kunststoff, angeordnet werden. Auch dieses Material weist zweckmäßig eine Öffnung auf, die derjenigen des ferromagnetischen lamellenförmigen Elementes entspricht, vorzugsweise gleich ist.

Die weichmagnetischen lamellenförmigen Elemente werden zweckmäßig aus einem Material mit hoher Permeabilität hergestellt, z.B. aus MU-Metall oder Permalloy.

Ausführungsbeispiele der Erfindung werden nachstehend anhand der Zeichnung näher erläutert, in der
- Fig. 1 und 2: einen Stromwandler nach der Erfindung in Seitansicht und im Schnitt durch die Spule mit einem runden Primärleiter darstellen, während
- Fig. 3 und 4: entsprechende Darstellungen für eine Primärmärleitung mit rechteckigem Querschnitt wiedergeben.
- Fig. 5, 6, 7 und 8: zeigen solche Stromwandler in perspektivischer Darstellung, während
- Fig. 9 und 10: einen Stromwandler nach Figur 5 in zusammengebautem Zustand in Aufsicht und, teilweise im Schnitt, in Seitenansicht zeigen.

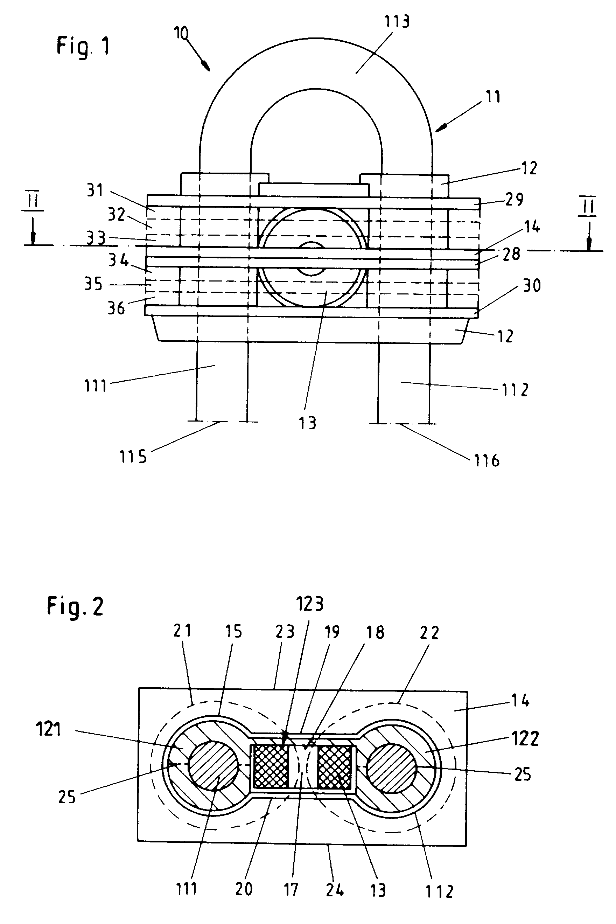

Nach Figur 1 wird eine etwa U-förmige Leiter-Schleife 11 gebildet durch einen Leiter, z.B. aus Kupfer, der zu einem ersten und einem zweiten geraden Schenkel 111 bzw. 112 und einem diese beiden Schenkel verbindenden Bogen 113 geformt ist. Die Schenkel 111 und 112 werden an ihren Enden 115 und 116 mit dem zu messenden Strom verbunden. Auf den Schenkeln 111 und 112 ist ein Kunststoff-Träger 12 angebracht, der die im Querschnitt rund ausgebildeten Schenkel 111 bzw. 112 isolierend umschließt und miteinander verbindet, wobei im Raum zwischen diesen Schenkeln eine Spule 13 mit z.B. 1000 Windungen angeordnet ist. Die Achse der Spule 13 steht senkrecht auf der Ebene der Leiterschleife 11 derart, daß die Spulenwindungen zu dieser Ebene etwa parallel liegen, so daß die beabsichtigte transformatorische Wirkung eintreten kann.

Mindestens ein flaches, aus wechmagnetischem Material bestehendes lamellenförmiges Element 14, dessen Ebene zur Ebene der U-förmigen Leiter-Schleife 11 wenigstens annähernd senkrecht steht, bildet einen die U-förmige Leiter-Schleife 11 und die Spule 13, vorzugsweise im Bereich der geraden Schenkel 111 und 112, umschließenden Mantel, wie insbesondere Figur 2 zu entnehmen ist. Dieser Mantel wirkt als Abschirmung gegenüber Fremdfeldern. In dem Elemnt 14 ist eine längliche, durch ihre Begrenzungslinie bezeichnete Öffnung 15 angebracht. Diese ist an ihren rechts und links dargestellten Enden etwa rund gestaltet als Durchlaß für die runden Leiter der Schenkel 111 und 112 mit einer sie umgebenden Hülle, die durch rohrförmige Teile 121 bzw. 122 des Kunststoff-Trägers 12 in Fig. 1 gebildet wird.

Durch die rohrförmigen Teile 121 und 122, deren Wandstärke auch im Hinblick auf die erforderliche elektrische Isolation gewählt ist, sind die geraden Schenkel 111 und 112 der Leiter-Schleife 11 gesteckt.

Zwischen den Teilen 121 und 122 ist ein Verbindungs-Teil 123 angebracht. Die Spule 13 wird in ihrer Position gehalten durch eine ihrer Form angepaßte Vertiefung in diesem Verbindungs-Teil 123 des Kunststoffträgers 12, der bei der Spule 13 einen Boden 18 bildet mit einer Öffnung auf der gegenüberliegenden Seite, von der die Spule 13 in den Kunststoff-Träger 12 eingelegt werden kann.

Das Element 14 trägt benachbart zu dem für die Spule vorgesehenen Bereich in der Öffnung 15 Vorsprünge 19 und 20, die in der Ebene des lamellenförmigen Elementes 14 liegen und zwischen denen ein Raum frei ist, in dem die Spule 13, ggf. mit einem nicht dargestellten Spulenkörper, angeordnet werden kann. Dabei kann der Raum zwischen den Vorsprüngen 19 und 20 größer sein als die Dicke der Leiter 11 senkrecht zur Leiterebene. Die Magnetfeldlinien, von denen je eine 21 bzw. 22 um jeden der Leiter 11 dargestellt ist, verlaufen durch das ferromagnetische Material des Elementes 14 zu den Vorsprüngen 19 bzw. 20 und dann durch den zwischen den Vorsprüngen 19 und 20 gebildeten Luftspalt, wobei sie dem Primärleiter-Strom entsprechende Spannungen in den Windungen der Spule 13 induzieren. Die Vorsprünge 19 und 20 wirken so gegenüber der Spule 13 wie Polschuhe.

Die Wicklungs-Enden der Spule 13 können in nicht dargestellter Weise, z.B. über Lötanschlüsse, mit einer Schaltungsanordnung verbunden sein, die die induzierten Spannungen als Meßwerte für den primären Strom auswertet und z.B. einem Elektrizitätszähler zuführt. Durch die Formgebung des Elementes 14 wird der, insbesondere zur Vermeidung von Sättigung erforderliche, Soll-Luftspalt gebildet. Die ferromagnetischen Teile des Magnetkreises sind durch die Form der Lamelle 14 festgelegt und brauchen so nicht justiert zu werden. Insbesondere kann sich dabei nichts verschieben, so daß auch eine hohe Langzeitstabilität gewährleistet ist.

Das lamellenförmige Element 14 wird begrenzt von zwei, in Fig. 2 oben und unten dargestellten Längsseiten 23 und 24, die zur Ebene der U-förmigen Leiter-Schleife 11 annähernd parallel verlaufen. Die Höhe des lamellenförmigen Elementes 14 zwischen der an den Luftspalt grenzenden Kante eines Vorsprunges 19 bzw. 20 bis zur zugeordneten Längsseite 23 bzw. 24 soll wenigstens annähernd so groß sein wie der halbe Außendurchmesser der Spule 13 (vgl. Figur 1). Die Gesamthöhe des lamellenförmigen Elementes 14 zwischen den gegenüberliegenden Außenseiten 23 und 24 soll mindestens zweimal, vorzugsweise etwa dreimal, so groß sein wie der Abstand zwischen den Vorsprüngen 19 und 20. Dadurch ist sichergestellt, daß der Magnetfeld-Fluß in der gewünschten Weise durch die zum Messen dienende Spule 13 hindurchgeht und nur unwesentlich den Außenraum durchsetzt. Die Spule 13 ist, wie die Figuren 1 und 2 zeigen, flach ausgebildet mit einem Außendurchmesser der größer, z.B. dreimal so groß, ist im Vergleich zur Spulen-Höhe. Die Spulen-Höhe ist etwas kleiner als der Raum zwischen den Vorsprüngen 19 und 20; es ist daher leicht möglich, die lamellenförmigen Elemente 14 von der Seite, etwa parallel zur Ebene des U der Leiter-Schleife 11, über den Bogen 113 über die Spule 13 schieben.

Ein aus einem Stück bestehender Kunststoff-Träger 12 kann von der dem Bogen 113 abgewandten Seite der Leiter-Schleife 11, in Figur 1 also von unten, von den Enden 115 und 116 her an den geraden Schenkeln 111 und 112 entlang aufgeschoben werden. Die Leiter-Schleife 11 wird danach im Gerät, z.B. in einem Elektrizitäts-Zähler, mit ihren Enden 115 und 116 an den Meß-Stromkreis angeschlossen.

Der Kunststoff-Träger 12 kann aus zwei Teilen bestehen, wobei die Teilung entsprechend den in Figur 2 gestrichelt dargestellten Linien 25 vorgenommen ist in einer Ebene, die parallel zur Ebene der Leiter-Schleife 11 in Höhe der Mitte der runden Leiter der Schenkel 111 und 112 verläuft. Dann können die Teile des Kunststoff-Trägers von oben und von unten auf die Schenkel aufgelegt werden, ohne daß die Enden 115 und 116 offen sind und zugängig zu sein brauchen.

Die Lamellen 14 können, wenn der Raum zwischen den Vorsprüngen 19 und 20 größer ist als die Dicke des Bogens 113 senkrecht zur Ebene der Leiter-Schleife 11, über den Bogen 113 aufgeschoben und in an sich bekannter Weise bei der Spule 13 fixiert werden.

Nahe der Mitte der Spule 13 kann außer dem lamellenförmigen Element 14 noch ein weiteres lamellenförmiges Element 28 parallel angeordnet werden, wobei die Elemente 14 und 28 vorzugsweise gegeneinander elektrisch isoliert sind. Erforderlichenfalls können auch noch weitere lamellenförmige Elemente parallel angebracht werden.

Außer wenigstens einem lamellenförmigen Element 14 in der Nähe der Spulenmitte können auch ein oder mehrere weichmagnetische lamellenförmige Elemente 29 und 30 außen etwa am Spulenrand angeordnet werden. Diese dienen insbesondere dazu, die Spule 13 gegenüber äußeren Fremdfeldern abzuschirmen. In den Abständen zwischen den Elementen 14 und 29 bzw. 28 und 30 können, vorzugsweise ebenfalls lamellenförmige, Zwischen-Elemente 31 bis 36 angeordnet werden, die durch gestrichelte Linien angedeutet sind. Sie können beliebige Dicke haben; sie weisen jedoch die gleiche Öffnung auf, wie das lamellenförmige Element 14 (vergl. Figur 2), so daß sie mit einem gleichartigen Werkzeug hergestellt werden können. Die Zwischen-Elemente 31 bis 36 dienen im wesentlichen der Ausfüllung des Zwischenraumes und der Halterung der magnetisch leitenden Elemente 14, 28, 29, 30. Sie können aus einem Kunststoff oder auch aus einem nichtmagnetischen Metall wie Aluminium und/oder aus magnetischen Material bestehen.

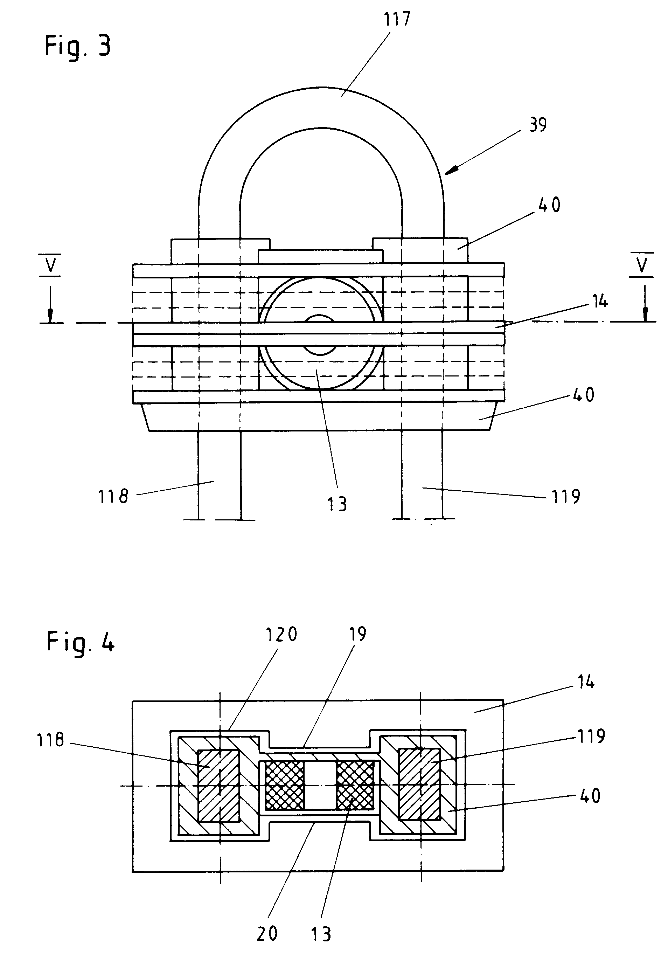

Die Figuren 3 und 4 stellen in Seitenansicht bzw. im Schnitt einen Stromwandler nach der Erfindung dar, der im wesentlichen dem nach Figur 1 und 2 entspricht, bei dem jedoch der eine Leiter-Schleife 39 mit einem Bogen 117 und Schenkeln 118 und 119 bildende Stromleiter im Querschnitt rechteckig ausgebildet ist, wobei dementsprechend auch die Öffnungen in einem Kunststoff-Träger 40 geformt sind, während die übrigen Dimensionen und Anordnungen gegenüber Figur 1 und 2 etwa gleich sind.

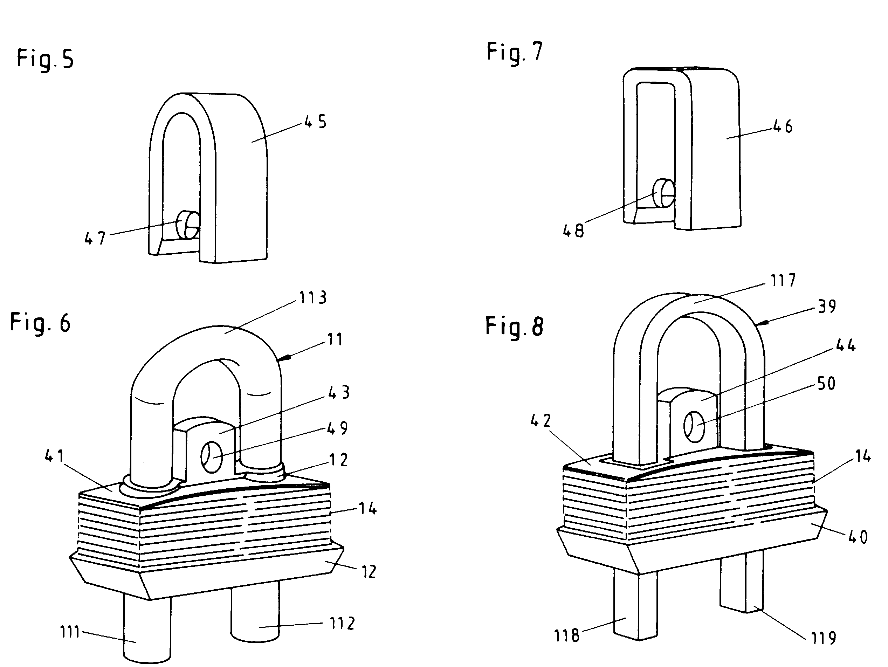

Die Figuren 5 und 6 bzw. 7 und 8 zeigen je einen Stromwandler nach der Erfindung, dessen U-förmige Leiter 11 bzw. 39 im Querschnitt rund bzw. rechteckig, etwa im Verhältnis 1:2, ausgebildet ist. Dabei ist der Kunststoff-Träger 12 bzw. 40 mit einem Paket lamellenförmiger Elemente 14 usw., wie sie anhand der Figuren 1 bis 4 beschrieben wurden, zusammengebaut und wird unter dem Druck einer Blatt-Feder 41 bzw. 42 zusammengehalten.

Innerhalb des Bogens 113 bzw. 117 des Leiters 11 bzw. 39 ist eine an dem Kunststoffträger 12 bzw. 40 angebrachte Öse 43 bzw. 44 angeordnet. Der zugehörige Kunststoff-Träger 12 bzw. 40 mit dem Lamellenpaket kann in die betriebsmäßige Position nach oben geschoben werden, derart, daß die Oberseite der Öse 43 bzw. 44 an der unteren Innenseite des Bogens 112 bzw. 117 der Leiter-Schleife 11 bzw. 39 anliegt. Dann kann ein Befestigungsbügel 45 nach Figur 5 bzw. 46 nach Figur 7 von außen über den Bogen 112 bzw. 117 übergeschoben werden, derart, daß Ansätze 47 bzw. 48 in öffnungen 49 bzw. 50 an der Öse 43 bzw. 44 eingreifen. Die Befestigungsbügel 45 bzw. 46 tragen je zwei derartige Ansätze an ihren gegenüberliegenden Enden, von denen jedoch in Figuren 5 bzw. 7 nur einer (47 bzw. 48) sichtbar ist. Durch den Bügel 45 bzw. 46 wird so das Lamellenpaket mit der in seinem Innern angeordneten Meßspule für den Betrieb im Bogen 113 bzw. 117 des U-förmigen Leiters 11 bzw. 39 festgehalten, so daß eine, ggf. das Transformationsverhältnis und den von der Spule abgenommenen Meßwert beeinflussende Verschiebung verhindert wird.

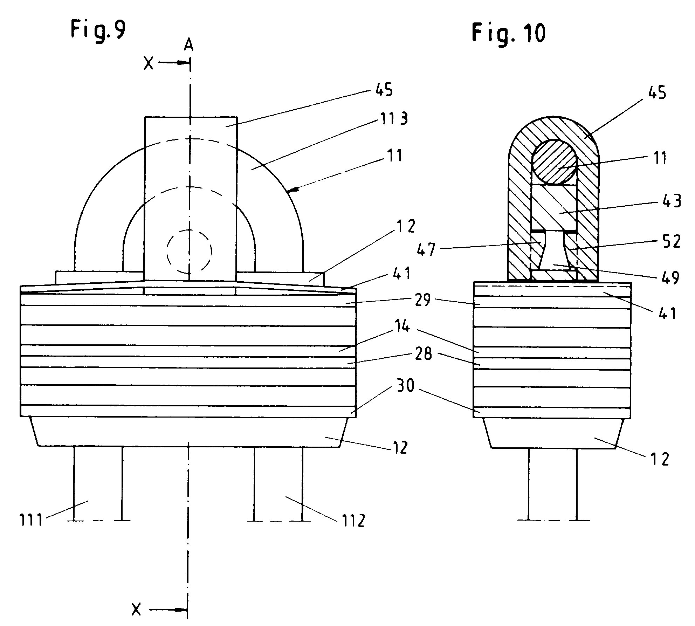

Die Figuren 9 und 10 zeigen in Seitenansicht bzw. im Schnitt entlang der gestrichelten Linie A bis zur Feder 41 eine Anordnung nach Figur 5 und 6 im zusammengebauten Zustand. Dabei ist in Figur 10 auch der in Figur 5 nicht sichtbare zweite Ansatz 52 am Befestigungsbügel 45 erkennbar, der dem Ansatz 47 gegenüberliegt.

## Patentansprüche

1. Stromwandler (10) mit einem vom zu messenden Strom durchflossenen, wenigstens annähernd in einer Ebene liegende, etwa U-förmigen Leiter-Schleife (11,39) bildenden Leiter, in dessen Innerem eine an einen elektronischen Elektrizitätszähler anschließbare Spule (13) angeordnet ist, deren Windungen zur Ebene der Leiter-Schleife (11,39) wenigstens annähernd parallel liegen, wobei die Leiter-Schleife (11,39) und die Spule (13) von einem, auch als Abschirmung wirkenden Mantel aus magnetisch leitendem Material umschlossen sind,
dadurch gekennzeichnet,
daß der weichmagnetische Mantel gebildet wird durch mindestens ein flaches, lamellenförmiges Element (14), dessen Ebene zur Ebene der Leiter-Schleife (11,39) wenigstens annähernd senkrecht steht und daß die U-förmige Leiter-Schleife (11,39) gebildet wird durch zwei gerade Schenkel (111, 112; 118, 119) und einen die beiden Schenkel verbindenden Bogen (113; 117) und daß das lamellenförmige Element (14) eine längliche Öffnung (15, 120) trägt, die an ihren Enden als Durchlaß für die Schenkel (111, 112; 118, 119) der Leiter-Schleife (11; 39) ausgebildet ist und die dazwischen Platz für die Spule (13) bietet und daß der die Öffnung (15; 120) umschließende Teil des Elementes (14) benachbart zu dem für die Spule (13) vorgesehenen Bereich mit wenigstens einem, in der Ebene des lamellenförmigen Elementes (14) liegenden Vorsprung (19,20) versehen ist.

2. Stromwandler nach Anspruch 1,
dadurch gekennzeichnet,
daß der Durchlaß in der Öffnung (15) für die Schenkel (111 und 112) an deren Querschnitt zuzüglich einer elektrischen Isolierschicht (16) angepaßt ist.

3. Stromwandler nach Anspruch 2,
dadurch gekennzeichnet,
daß der Durchlaß in der Öffnung (15) für einen runden Leiter (11) angepaßt ist.

4. Stromwandler nach Anspruch 2,
dadurch gekennzeichnet,
daß der Durchlaß in der Öffnung (120) für einen etwa rechteckigen Leiter (118) angepaßt ist, dessen Höhe senkrecht zur Leiterebene größer, z. B. 1,5 bis 3 mal größer, ist als seine Breite in der Leiterebene.

5. Stromwandler nach Anspruch 1, 2 , 3 oder 4,
dadurch gekennzeichnet,
daß der die Öffnung (15) umschließende Teil des Elementes (14) benachbart zu dem für die Spule (13) vorgesehenen Bereich mit zwei, in der Ebene des lamellenförmigen Elementes (14) gegenüberliegenden Vorsprüngen (19 und 20) versehen ist.

6. Stromwandler nach Anspruch 5,
dadurch gekennzeichnet,
daβ zwischen den Vorsprüngen (19 und 20) ein Raum frei ist, in dem die Spule (13), gegebenenfalls mit einem Spulenkörper, angeordnet werden kann.

7. Stromwandler nach einem der Ansprüche 1 bis 6,
dadurch gekennzeichnet,
daß der Raum zwischen den Vorsprüngen (19 und 20) größer ist als die Dicke der geraden Schenkel (111, 112) senkrecht zur Leiterebene.

8. Stromwandler nach Anspruch 6 oder 7,
dadurch gekennzeichnet,
daß der freie Raum zwischen den Vorsprüngen (19 und 20) den für den Betrieb des Stromwandlers (10) erforderlichenen Solluftspalt bildet.

9. Stromwandler nach einem der Ansprüche 1 bis 8,
dadurch gekennzeichnet,
daß die Höhe des lamellenförmigen Elementes (14) zwischen der an den Luftspalt grenzenden Kante eines Vorsprunges (19, 20) bis zur Außenseite (23 bzw. 24) wenigstens annähernd so groß ist wie der halbe Außendurchmesser der Spule (13).

10. Stromwandler nach einem der Ansprüche 2 bis 9,
dadurch gekennzeichnet,
daß die Gesamt-Höhe des lamellenförmigen Elementes (14) zwischen den gegenüberliegenden Außenseiten (23 und 24) mindestens zweimal, vorzugsweise etwa dreimal, so groß ist wie der Abstand zwischen den Vorsprüngen (19 und 20).

11. Stromwandler nach einem der Ansprüche 1 bis 10,
dadurch gekennzeichnet,
daß die Spule (13) ohne ferromagnetischen Kern ausgebildet ist.

12. Stromwandler nach einem der Ansprüche 1 bis 11,
dadurch gekennzeichnet,
daß die Spule (13) flach ausgebildet ist mit einem Außendurchmesser, der größer ist als die Spulen-Höhe.

13. Stromwandler nach einem der Ansprüche 3 bis 12,
dadurch gekennzeichnet,
daß die Spulenhöhe etwas, z. B. ein bis zwei Millimeter, kleiner ist als der Raum zwischen der Vorsprüngen (19 und 20).

14. Stromwandler nach einem der Ansprüche 1 bis 13,
dadurch gekennzeichnet,
daß die Spule (13) im Mittelstück (123) eines Trägers (12) aus isolierendem Material gehaltert ist, das an seinen Seiten mit etwa rohrförmigen Teilen versehen ist, durch die die geraden Schenkel (111 bzw. 112) der Leiter-Schleife (12) hindurchgeführt werden können.

15. Stromwandler nach Anspruch 14,
dadurch gekennzeichnet,
daß der Kunststoff-Träger (12) aus einem Stück besteht, das auf die geraden Schenkel (111 und 112) der Leiter-Schleife (11) aufgesteckt werden kann.

16. Stromwandler nach einem der Ansprüche 1 bis 14,
dadurch gekennzeichnet,
daß die Spule (13) auf einem aus, vorzugsweise zwei, Teilen bestehenden, Träger (12) aus isolierendem Material angebracht ist.

17. Stromwandler nach Anspruch 16,
dadurch gekennzeichnet,
daß der Träger (12) parallel zur Schleifenebene in Höhe der Mitte der Schenkel (111, 112) geteilt und so von oben und unten montierbar ist.

18. Stromwandler nach einem der vorangehenden Ansprüche ,
dadurch gekennzeichnet,
daß wenigstens ein lamellenförmiges Element (14) nahe der Mitte der Spule (13) angeordnet ist.

19. Stromwandler nach Anspruch 18,
dadurch gegekennzeichnet,
daß nahe der Mitte der Spule (13) zwei oder mehr lamellenförmige Elemente (14, 28) vorzugsweise gegeneinander elektrisch isoliert, angeordnet sind.

20. Stromwandler nach einem der vorangehenden Ansprüche,
dadurch gekennzeichnet,
daß wenigstens ein lamellenförmiges Element (29;30) etwa am Rand der Spule (13) angeordnet ist.

21. Stromwandler nach einem der vorangehenden Ansprüche 19,20 oder 21,
dadurch gekennzeichnet,
daß zwischen zwei benachbarten magnetisch leitenden, lamellenförmigen Elementen (14 und 29; 28 und 39) nichtmagnetisches Material (31 bis 36) angeordnet ist.

22. Stromwandler nach Anspruch 21,
dadurch gekennzeichnet,
daß das nichtmagnetische Material (31 bis 36) aus Aluminium besteht.

23. Stromwandler nach Anspruch 21,
dadurch gekennzeichnet,
daß das nichtmagnetische Material (31 bis 36) aus wenigstens einem Kunststoff besteht.

## Claims

1. Current transducer (10) with a conductor flowed through with a current to be measured and forming a roughly U-shaped conductor loop (11,39) located at least approximately in one plane, in whose interior a coil (13) is disposed which is connectable to an electronic electricity meter, whose turns are located at least approximately parallel to the plane of the conductor loop (11,39), in which case the conductor loop (11,39) and the coil (13) are enclosed by a sheathing of magnetically conductive material which also acts as a screen,
**characterized in that**
the soft magnetic sheathing is formed by at least one flat lamellar element (14), whose plane is disposed at least approximately vertically to the plane of the conductor loop (11,39) and in that the U-shaped conductor loop (11,39) is formed by two straight legs (111, 112, 118, 119) and an arc (113; 117) interconnecting the two legs and in that the lamellar element (14) carries an oblong aperture (15, 120), which, on its ends, is constructed as a passage for the legs (111, 112; 118, 119) of the conductor loop (11; 39) and which, in between, offers space for the coil (13) and in that the portion of the element (14) surrounding the aperture (15; 120), adjacent to the region provided for the coil (13), is provided with at least one projecting portion (19, 20) located in the plane of the lamellar element (14).

2. Current transducer according to Claim 1,
**characterized in that**
the passage in the aperture (15) for the legs (111 and 112) is adapted to the cross-section of the same additionally to an electric insulation layer (16).

3. Current transducer according to Claim 2,
**characterized in that**
the passage in the aperture (15) is adapted to a circular conductor (119.

4. Current transducer according to Claim 2,
**characterized in that**
the passage in the aperture (120) is adapted to a roughly rectangular conductor (118), whose height vertically to the conductor plane is larger, e.g. 1.5 to 3 times larger than its width in the conductor plane.

5. Current transducer according to Claim 1, 2, 3 or 4,
**characterized in that**
that the portion of the element (14) surrounding the aperture (15), adjacent to the area provided for the coil (13), is provided with two projecting parts (19 and 20) located opposite each other in the plane of the lamellar element.

6. Current transducer according to Claim 5,
**characterized in that**,
between the projecting parts (19 and 20), a space is open wherein the coil (13), if necessary with a coil body, can be disposed.

7. Current transducer according to any of Claims 1 to 6,
**characterized in thas**
the space between the projecting parts (19 and 20) is larger than the thickness of the straight legs (111, 112) vertically to the conductor plane.

8. Current transducer according to any of Claims 1 to 6,
**characterized in that**
the open space between the projecting parts (19 and (20) forms the nominal air gap necessary for the operation of the current transducer (10).

9. Current transducer according to any of Claims 1 to 8,
**characterized in that**
height of the lamellar element (14) between the edge of a projecting part (19, 20) bordering on the air gap to the outside (23 or 24) is at least approximately as great as half the external diameter of the coil (13).

10. Current transducer according to any of Claims 2 to 9,
**characterized in that**
the overall height of the lamellar element (14) between the oppositely located outsides (23 and 24) is at least twice, but perferably roughly three times as large as the distance between the projecting parts (19 and 20).

11. Current transducer according to any of Claims 1 to 10,
**characterized in that**
the coil (13) is constructed without a ferromagnetic core.

12. Current transducer according to any of Claims 1 to 11,
that the coil (13) is of flat construction and possesses an external diameter which is larger than the height of the coil.

13. Current transducer according to any of Claims 3 to 12,
**characterized in that**
the coil height is somewhat, e.g. one to two millimetres, smaller than the space between the projecting parts (19 and 20).

14. Current transducer according to any of Claims 1 to 13,
**characterized in that**
the coil (13) is mounted in the central portion (123) of a support (12) of insulating material which, on its sides, is provided with roughly tubular parts, through which the straight legs (111 or 112) of the conductor loop (11) can be passed.

15. Current transducer according to Claim 14,
**characterized in that**
the plastic support (12) is comprised of one piece which can be inserted upon the straight legs (111 and 112) of the conductor loop (11).

16. Current transducer according to any of Claims 1 to 14,
**characterized in that**
the coil (13) is mounted on a support (12) that is preferably comprised of two portions of insulating material.

17. Current transducer according to Claim 16,
**characterized in that**
the support (12) is divided parallel to the conductor loop plane at the level of the center of the legs (111, 112) and can then be mounted both from above as well as from below.

18. Current transducer according to any of the preceding claims,
**characterized in that**
at least one lamellar element (14) is disposed close to the center of the coil (13).

19. Current transducer according to Claim 18,
**characterized in that**,
close to the center of the coil (13), two or more lamellar elements (14, 28) are disoosed which are preferably electrically insulated relative to each other.

20. Current transducer according to any of the preceding claims,
**characterized in that**
at least one lamellar element (29; 30) is disposed roughly on the rim of the coil (13).

21. Current transducer according to any of Claims 19, 20 or 21,
**characterized in that**
between the two adjacent magnetically conductive lamellar elements (14 and 29; 28 and 39), non-magnetic material (31 to 36) is disposed.

22. Current transducer according to Claim 21,
**characterized in that**
the non-magnetic material (31 to 36) is comprised of aluminium.

23. Current transducer according to Claim 21,
**characterized in that**
the non-magnetic material (31 to 36) is comprised of at least one plastic.

## Revendications

1. Transducteur (10) avec un conducteur traversé par le courant à mesurer, qui forme une boucle de conducteur (11, 39) à peu près en forme d'U, qui se situe au moins approximativement dans un plan, conducteur à l'intérieur duquel est placée une bobine (13), qui peut être raccordée à un compteur électronique d'énergie électrique, dont les spires sont au moins approximativement parallèles au plan de la boucle de conducteur (11, 39), la boucle de conducteur (11, 39) et la bobine (13) étant entourées par une enveloppe, qui a également un effet d'écran, en matériau magnétoconducteur,
**caractérisé en ce**
que l'enveloppe magnétique douce est formée par au moins un élément plat en forme de lamelle (14), dont le plan est au moins approximativement perpendiculaire au plan de la boucle de conducteur (11, 39), et que la boucle de conducteur (11, 39) en forme d'U est formée par deux montants droits (111, 112 ; 118, 119) et un arc (113 ; 117) qui relie les deux montants et que l'élément en forme de lamelle (14) porte une ouverture allongée (15, 120) qui est configurée à ses extrémités comme passage pour les montants (111, 112 ; 118, 119) de la boucle de conducteur (11 ; 39) et qui offre là entre de la place pour la bobine (13) et que la partie de l'élément (14) qui entoure l'ouverture (15 ; 120) est pourvue, au voisinage de la zone prévue pour la bobine (13), d'au moins une saillie (19, 20) qui se situe dans le plan de l'élément en forme de lamelle (14).

2. Transducteur selon la revendication 1,
**caractérisé en ce**
que le passage dans l'ouverture (15) pour les montants (111 et 112) est adapté à la section de celle-ci plus une couche isolante électrique (16).

3. Transducteur selon la revendication 2,
**caractérisé en ce**
que le passage dans l'ouverture (15) est adapté pour un conducteur rond (11).

4. Transducteur selon la revendication 2,
**caractérisé en ce**
que le passage dans l'ouverture (120) est adapté pour un conducteur (118) à peu près rectangulaire dont la hauteur perpendiculairement au plan du conducteur est plus grande, par exemple d'1,5 à 3 fois plus grande, que sa largeur dans le plan du conducteur.

5. Transducteur selon la revendication 1, 2, 3 ou 4,
**caractérisé en ce**
que la partie de l'élément (14) qui entoure l'ouverture (15) est pourvue, au voisinage de la zone prévue pour la bobine (13), de deux saillies (19 et 20) situées en face l'une de l'autre dans le plan de l'élément en forme de lamelle (14).

6. Transducteur selon la revendication 5,
**caractérisé en ce**
qu'un espace est libre entre les saillies (19 et 20), espace dans lequel la bobine (13) peut être placée, le cas échéant avec une armature de bobine.

7. Transducteur selon l'une des revendications 1 à 6,
**caractérisé en ce**
que l'espace entre les saillies (19 et 20) est plus grand que l'épaisseur des montants droits (111, 112) perpendiculairement au plan du conducteur.

8. Transducteur selon la revendication 6 ou 7,
**caractérisé en ce**
que l'espace libre entre les saillies (19 et 20) forme la discontinuité magnétique nominale nécessaire pour le fonctionnement du transducteur (10).

9. Transducteur selon l'une des revendications 1 à 8,
**caractérisé en ce**
que la hauteur de l'élément en forme de lamelle (14) entre l'arête, adjacente à la discontinuité magnétique, d'une saillie (19, 20) et la face extérieure (23 ou 24) est au moins approximativement aussi grande que la moitié du diamètre extérieur de la bobine (13).

10. Transducteur selon l'une des revendications 2 à 9,
**caractérisé en ce**
que la hauteur totale de l'élément en forme de lamelle (14) entre les faces extérieures opposées (23, 24) est d'au moins deux fois, de préférence trois fois, aussi grande que l'écart entre les saillies (19 et 20).

11. Transducteur selon l'une des revendications 1 à 10,
**caractérisé en ce**
que la bobine (13) est configurée sans noyau ferromagnétique.

12. Transducteur selon l'une des revendications 1 à 11,
**caractérisé en ce**
que la bobine (13) est de forme plate avec un diamètre extérieur supérieur à la hauteur de la bobine.

13. Transducteur selon l'une des revendications 3 à 12,
**caractérisé en ce**
que la hauteur de la bobine est un peu plus petite, par exemple d'un à deux millimètres, que l'espace entre les saillies (19 et 20).

14. Transducteur selon l'une des revendications 1 à 13,
**caractérisé en ce**
que la bobine (13) est maintenue dans la pièce centrale (123) d'un support (12) en matériau isolant qui est pourvu, sur ses côtés, de pièces à peu près en forme de tuyau à travers lesquelles les montants droits (111 ou 112) de la boucle de conducteur (12) peuvent passer.

15. Transducteur selon la revendication 14,
**caractérisé en ce**
que le support en plastique (12) est constitué par une pièce qui peut être emboîtée sur les montants droits (111 et 112) de la boucle de conducteur (11).

16. Transducteur selon l'une des revendications 1 à 14,
**caractérisé en ce**
que la bobine (13) est fixée sur un support (12) en matériau isolant constitué de préférence par deux pièces.

17. Transducteur selon la revendication 16,
**caractérisé en ce**
que le support (12) est divisé parallèlelement au plan de la boucle à hauteur du milieu des montants (111, 112) et peut ainsi être monté par le haut et par le bas.

18. Transducteur selon l'une des revendications précédentes,
**caractérisé en ce**
qu'au moins un élément en forme de lamelle (14) est placé près du milieu de la bobine (13).

19. Transducteur selon la revendication 18,
**caractérisé en ce**
que deux éléments en forme de lamelle (14, 28) ou plus sont placés près du milieu de la bobine (13), en étant de préférence isolés électriquement l'un contre l'autre.

20. Transducteur selon l'une des revendications précédentes,
**caractérisé en ce**
qu'au moins un élément en forme de lamelle (29 ; 30) est placé à peu près au bord de la bobine (13).

21. Transducteur selon l'une des revendications précédentes 19, 20 ou 21,
**caractérisé en ce**
qu'un matériau non magnétique (31 à 36) est placé entre deux éléments en forme de lamelle (14 et 29 ; 28 et 39) voisins magnétoconducteurs.

22. Transducteur selon la revendication 21,
**caractérisé en ce**
que le matériau non magnétique (31 à 36) est constitué par de l'aluminium.

23. Transducteur selon la revendication 21,
**caractérisé en ce**
que le matériau non magnétique (31 à 36) est constitué par au moins une matière plastique.
